# EUROPÄISCHE PATENTSCHRIFT

(11) **EP 2 745 354 B1**
(45) Veröffentlichungstag und Bekanntmachung des Hinweises auf die Patenterteilung: **10.05.2017**
(21) Anmeldenummer: 12740301.2
(22) Anmeldetag: 26.06.2012
(51) Int. Cl.: H01R 13/03, H01R 13/652, H01R 13/6585, H05K 9/00, H01R 13/6599, H01R 13/6471, H01R 13/6587

(54) **ISOLIERKÖRPER MIT SCHIRMKREUZ**
INSULATING MEMBER HAVING A CRUCIFORM SHIELD
CORPS ISOLANT POURVU D'UN ÉLÉMENT DE BLINDAGE EN FORME DE CROIX

(30) Priorität: 18.08.2011 DE 102011052792
(43) Veröffentlichungstag der Anmeldung: 25.06.2014
(73) Patentinhaber: HARTING Electronics GmbH, 32339 Espelkamp (DE)
(72) Erfinder: SCHREIER, Stephan, 32369 Rahden (DE); GENAU, Melanie, 32312Lübbecke (DE); POST, Dirk Peter, 32312 Lübbecke (DE)
(86) Internationale Anmeldenummer: PCT/DE2012/100187
(87) Internationale Veröffentlichungsnummer: WO 2013/023645

(56) Entgegenhaltungen:
- EP-A1- 0 693 795
- EP-A1- 1 256 981
- EP-A1- 1 858 117
- EP-A1- 2 194 610
- FR-A1- 2 921 522
- US-A- 5 133 679
- US-A- 5 213 520
- US-A- 5 564 948
- US-A- 5 718 606
- US-A- 5 823 825
- US-A1- 2005 277 340

## Beschreibung

Die Erfindung betrifft einen Isolierkörper, der zur elektrischen Kontaktierung zumindest zweier Leiter eines anzuschließenden Kabels oder zum Aufbringen auf einer Leiterplatte vorgesehen ist, nach dem Oberbegriff des Anspruch 1.

Isolierkörper werden in dafür vorgesehene Kammern eines Steckverbindergehäuses eingesetzt. In der Regel umfassen die Isolierkörper Aufnahmen für Kontaktelemente, an welche die Leiter eines an den Steckverbinder anzuschließenden Kabels angeschlossen werden. Alternativ können die Kontaktelemente auch auf eine Leiterplatte aufgesteckt und verlötet werden.

In der Datenübertragungstechnik werden Isolierkörper mit so genannten Schirmbereichen eingesetzt. Die Schirmbereiche dienen dazu, zumindest zwei Leiter des anzuschließenden Kabels - und/oder die dazugehörigen Kontaktelemente - elektromagnetisch gegeneinander abzuschirmen.

Derartige Isolierkörper werden benötigt um mehrpolige Steckverbinder für analoge oder digitale Datenübertragung zu schaffen, die in geschirmten Ausführungen bei Frequenzen bis 600 MHz oder sogar höher einsetzbar sind.

Die EP 2 194 610 A1 zeigt einen Isolierkörper, der aus einem leitfähigen Polymer oder aus Metall durchsetztem Kunststoff (metal injection molding) bestehen kann.

Aus der EP 1 256 981 A1 ist eine ein galvanische Beschichtung einer Metalloberfläche mit einer Zinn oder einer Zinnlegierungsschicht bekannt. Die Zinn oder Zinnlegierungsschicht kann weiterhin mit Gold, Palladium, Rhodium, Ruthenium, Platinum, Kupfer, Silber, Iridium oder Bismut zur weiteren Beschichtung dotiert sein.

Die DE 43 41 104 C1 zeigt einen mehrpoligen Leiterplattensteckverbinder. Um den Steckverbinder gegenüber der Außenwelt elektromagnetisch abzuschirmen, wird vorgeschlagen, den Isolierkörper des Steckverbinders mit einer Metallisierung zu versehen. Um den Steckverbinder bei höheren Datenübertragungsraten einsetzen zu können, wird weiterhin vorgeschlagen, die Kontaktelemente am Isolierkörper mit metallisierten Kappen abzudecken.

Ein derartiger Steckverbinder besteht aus sehr vielen Einzelteilen und ist demnach aufwendig zu montieren.

Die Aufgabe der Erfindung besteht darin, einen Steckverbinder vorzuschlagen, der einfach montierbar und gleichzeitig vielseitig einsetzbar ist.

Die Aufgabe wird durch die kennzeichnenden Merkmale des Anspruchs 1 gelöst.

Vorteilhafte Ausgestaltungen der Erfindung sind in den Unteransprüchen angegeben.

In den erfindungsgemäßen Isolierkörper können Kontaktelemente montiert werden, die später das so genannte Steckgesicht des Steckverbinders bilden. An die jeweiligen Kontaktelemente werden die einzelnen Leiter des an den Steckverbinder anzuschließenden Kabels angeschlossen. Dies kann beispielsweise über eine Crimpverbindung geschehen. Aber jede andere Kontaktierung ist ebenfalls denkbar. Wird der erfindungsgemäße Isolierkörper als fertiger Steckverbinder auf einer Leiterplatte verbaut, werden die einzelnen Kontaktelemente in der Regel auf dieser festgelötet. Auch andere Kontaktierungsmethoden, beispielsweise Press-in-Pin, sind denkbar.

Im Folgenden wird mehrfach das Anschließen der Kontaktelemente des Isolierkörpers mit den einzelnen Leitern eines Kabels erwähnt. Darauf ist der erfindungsgemäße Isolierkörper jedoch nicht beschränkt. Eine Kontaktierung der Kontaktelemente auf eine Leiterplatte kann gleichwertig ebenso vorgesehen sein.

Der Isolierkörper wird in eine dafür vorgesehene Kammer eines Steckverbindergehäuses eingebracht. Am Steckverbindergehäuse ist in der Regel ein Kabelabgang vorgesehen. Durch die Öffnung des Kabelabgangs ragt das anzuschließende Kabel ins Innere des Steckverbindergehäuses hinein.

Innerhalb des Isolierkörpers werden einzelne Kontaktelemente oder Kontaktelementepaare durch ein Schirmelement voneinander elektromagnetisch abgeschirmt. In der Regel werden jeweils zwei Kontaktelemente als Paar gegenüber den anderen Zweierpaaren abgeschirmt.

In der Regel weist der Isolierkörper einen Hohlraum auf, in welchen ein metallisches so genanntes Schirmkreuz eingeschoben wird. Die Oberfläche des Schirmkreuzes ist dann in Kontakt mit der Oberfläche des Hohlraums. Dieses metallische Schirmkreuz bewirkt die oben beschriebene elektromagnetische Abschirmung zumindest zweier Kontaktelemente gegeneinander.

Die bislang bekannten Isolierkörper sind in der Regel von einem metallischen Kontaktring umgeben, der in leitendem Kontakt mit dem metallischen Schirmkreuz steht. Der Kontaktring wiederum steht in leitendem (Berühr)Kontakt mit der Innenwand der Kammer des Steckverbindergehäuses.

Der Isolierkörper besteht in der Regel aus nichtleitendem Material (Kunststoff). In der Regel wird ein Isolierkörper in einem Spritzgussverfahren hergestellt. Dabei wird Kunststoffmaterial in eine Spritzgussform (auch Werkzeug genannt) eingespritzt. Die Spritzgussform bestimmt dabei die Form und die Oberflächenstruktur des Isolierkörpers. Der erfindungsgemäße Isolierkörper wird in einem so genannten "zwei Komponenten Spritzgussverfahren" hergestellt.

Der Isolierkörper besteht aus zumindest zwei unterschiedlichen Komponenten, einer ersten und einer zweiten Komponente. Eine dieser Komponenten, die erste Komponente, ist mit einer Dotierung versehen. Die Dotierung dient als Katalysator für die Metallisierung der Oberfläche.

In einer vorteilhaften Ausführungsform handelt es sich bei der Dotierung um Palladiumkeime, die in den Kunststoff eingemischt sind.

Bei dem fertigen, in obigen Spritzgussverfahren hergestellten Isolierkörper wird zumindest ein Teil der Oberfläche der ersten Komponente, die auch als Schirmbereich bezeichnet wird, in einem elektrolytischen Bad durch einen galvanischen Prozess mit einem leitenden Überzug versehen. Dabei haftet an der Dotierung ein metallischer Stoff, vorzugsweise Kuper oder eine Kupferlegierung. Auf die Kupferoberfläche können in weiteren Arbeitsschritten andere Metallverbindungen aufgebracht werden. Dieser leitende Überzug bildet das Schirmelement des erfindungsgemäßen Isolierkörpers. Der Isolierkörper kann nach aussen abstehende Federbeine aufweisen, die von der ersten Komponente (mit Dotierung) ausgebildet werden. Im galvanischen Bad werden diese Federarme mit einem leitenden Überzug versehen. Die leitend überzogenen Federarme stehen in leitenden Kontakt mit dem Schirmelement. Beim Einführen des Isolierkörpers in die Kammer des Steckverbindergehäuses, stehen diese Federarme auch in leitendem Kontakt mit dem Gehäuse des Steckverbinders und erfüllen dieselbe Aufgabe wie der oben erwähnte metallische Kontaktring bei den bislang bekannten Isolierkörpern.

Ein erfindungsgemäßer Isolierkörper ist inklusive des Schirmelements (leitender Überzug) als einstückiges Bauteil ausgeführt. Die Kontaktelemente können direkt montiert werden. Ein zusätzlicher Montageschritt für das Schirmelement oder den metallischen Kontaktring entfällt.

In einer vorteilhaften Ausführungsform der Erfindung durchsetzt der Hohlraum den Isolierkörper in axialer Richtung kreuzförmig. Dadurch wird auch ein kreuzförmiger Metallüberzug im Isolierkörper erreicht. Dies ist besonders für einen achtpoligen Steckverbinder vorteilhaft. Es können jeweils Zweierpaare von Kontaktelementen gegeneinander abgeschirmt werden.

Bei zwölfpoligen Steckverbindern ist es vorteilhaft die axiale Durchsetzung des Hohlraums durch den Isolierkörper sternförmig zu gestalten. Bei einer symmetrischen Aufteilung der einzelnen Sternarme werden jeweils wieder Zweierpaare von Kontaktelementen gegeneinander abgeschirmt.

Es kann auch vorteilhaft sein, mehrere Hohlräume im Isolierkörper vorzusehen, die parallel zueinander ausgerichtet sind. Dadurch entstehen parallel zueinander ausgerichtete Schirmelemente. Dies ist besonders bei quaderförmigen Isolierkörpern vorteilhaft.

In Abhängigkeit von der Anzahl der Kontaktelemente und der technisch geforderten Abschirmung, kann die Form des erfindungsgemäßen Schirmelements variabel ausgeführt werden. Jede Form und Durchsetzung im Isolierkörper ist technisch realisierbar.

Im Folgenden wird das Herstellungsverfahren des erfindungsgemäßen Isolierkörpers beschrieben:
Wie bereits oben erwähnt, wird der Isolierkörper in einem ZweiKomponenten-Spritzgussverfahren, aus zumindest einer ersten und einer zweiten Komponente, hergestellt. Zumindest eine dieser Komponenten ist mit einer Dotierung versehen. Vorteilhafterweise handelt es sich bei der Dotierung um Palladiumkeime.

In einem ersten Arbeitsschritt wird die erste Komponente in die Spritzgussform eingespritzt. In der Regel ist die erste Komponente mit der oben erwähnten Palladium-Dotierung versehen. In diesem Fall bildet die erste Komponente den Oberflächenbereich aus, der später das Schirmelement bilden soll.

In einem zweiten Arbeitsschritt wird die zweite Komponente in die Spritzgussform eingeschossen und umschließt teilweise die erste Komponente, so dass die endgültige Form des Isolierkörpers gebildet ist. Der Oberflächenbereich für das Schirmelement ist bereits im ersten Arbeitsschritt in der ersten Komponente eingeformt und wird beim zweiten Arbeitsschritt nicht von der zweiten Komponente überdeckt.

Der ausgeformte Isolierkörper wird jetzt in ein Galvanisierungsbad getaucht. Durch einen nicht näher beschriebenen chemischen Prozess wird auf der noch freien Oberfläche der dotierten Komponente Kupfer abgeschieden. Auf dieser Kupferschicht können in weiteren Schritten nun weitere verschiedene Metalllagen aufgebracht werden. Die fertige Beschichtung bildet das Schirmelement.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Darstellung eines Isolierkörpers,

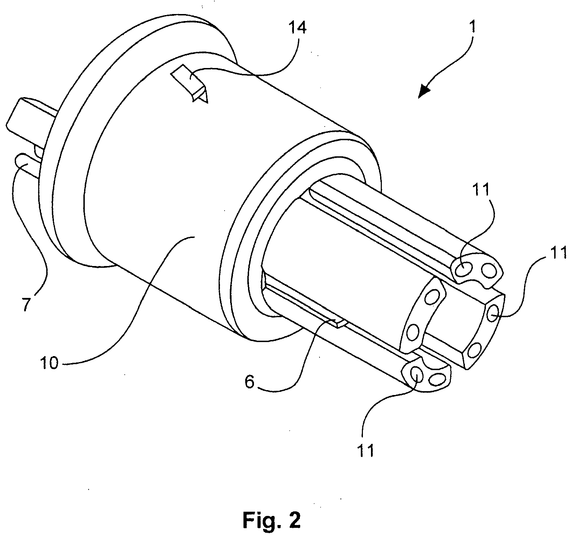

- Fig. 2: eine weitere perspektivische Darstellung eines Isolierkörpers,

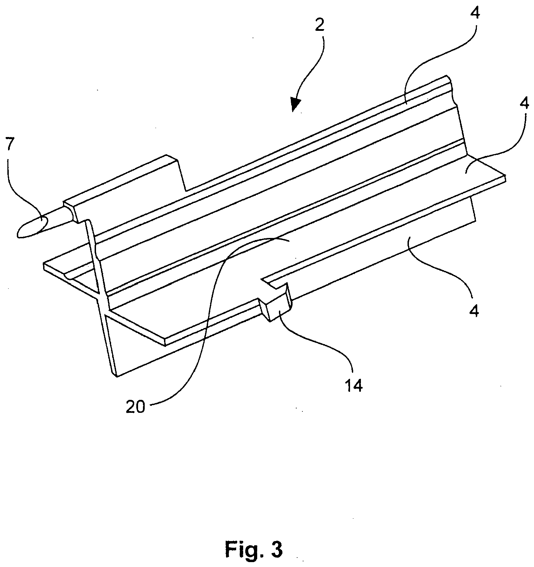

- Fig. 3: eine perspektivische Darstellung einer dotierten Komponente des Isolierkörpers,
- Fig. 4: eine perspektivische Darstellung einer weiteren Ausführungsform eines Isolierkörpers

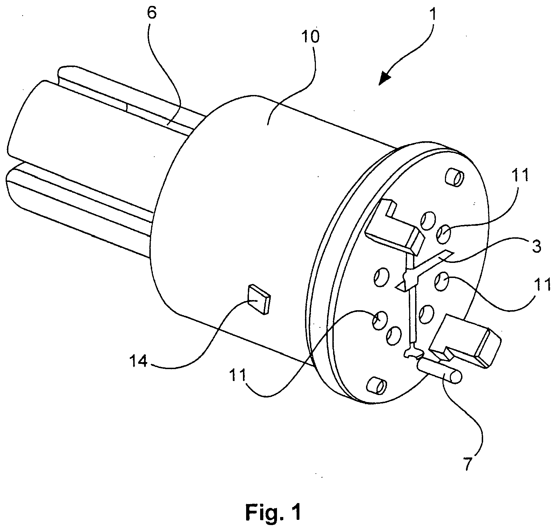

Die Figur 1 zeigt eine perspektivische Darstellung einer ersten Ausführungsform eines erfindungsgemäßen Isolierkörpers 1.
Der Isolierkörper 1 besteht aus einer ersten Komponente 2 und einer zweiten Komponente 10. Die erste Komponente ist mit einer Palladiumdotierung versehen und wir in einem galvanischen Bad mit einem leitenden Überzug 6 versehen, der das Schirmelement 20 bildet.
Der Isolierkörper 1 hat eine im Wesentlichen zylinderförmige Gestalt. Auf der Stirnseite sind Ausnehmungen 11 vorgesehen, welche zur Montage von Kontaktelementen (hier nicht gezeigt) geeignet sind. Der Isolierkörper 1 ist von einem kreuzförmigen Hohlraum 3 durchzogen. Weiterhin ist ein so genannter Schirmkontakt 7 vorgesehen, der den Kontakt zur Schirmübergabe leistet und beispielsweise für die Erdung des Steckverbinders vorgesehen ist. Der Schirmkontakt 7 wird dazu entweder an den Erdleiter des anzuschließenden Kabels oder an die Erdleitung der Leiterplatte angeschlossen. Der Schirmkontakt 7 kann aus einem Teil der ersten Materialkomponente 2 und dem sich darauf befindenden leitenden Überzug 6 bestehen. Alternativ kann der Schirmkontakt 7 auch aus einem separaten, metallischen Kontaktelement gebildet sein.
Aus der Mantelfläche des Isolierkörpers 1 ragen Federarme 14 hervor, die beim Einführen in eine Kammer eines Steckverbindergehäuses, mit selbiger in Berührkontakt stehen. Bei einem metallischen Gehäuse stehen sie Federarme 14 in leitenden Kontakt mit dem Gehäuse. Die erste Komponente 2 bildet die in leitenden Kontakt zueinander stehenden Elemente aus. Insgesamt stehen das Schirmelement 20, die Federarme 14 und der Schirmkontakt in leitendem Kontakt.

Die erste Komponente 2 des Isolierkörpers 1 hat im Wesentlichen die Form eines in den Raum extrudierten Kreuzes. Zwei Flügel 4 der ersten Komponente 2 bilden die oben erwähnten Federarme 14 aus. An einen dazu senkrecht angeordneten Flügel 4 ist der Schirmkontakt 7 angeformt.

Um die erste Komponente 2 wird eine zweite Komponente 10 gespritzt. Die Oberfläche der ersten Komponente 2, die nicht vom Material der zweiten Komponente 10 überdeckt wird, kann anschließend in einem galvanischen Bad mit einem leitenden Überzug 6 versehen werden.

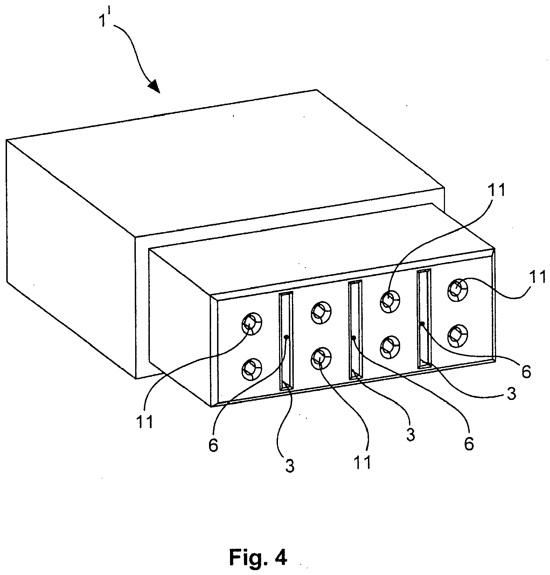

Die Figur 4 zeigt eine weitere Ausführungsform eines erfindungsgemäßen Isolierkörpers 1'. Der Isolierkörper 1' hat eine im Wesentlichen quaderförmige Form. Gleiche Elemente sind mit denselben Bezugszeichen versehen.

Der Isolierkörper 1' ist von drei zueinander parallelen Hohlräumen 3 durchzogen. Die Oberfläche der Hohlräume 3 wird vom Material der ersten, dotierten Kunststoffkomponente gebildet. In einem galvanischen Bad wird die Oberfläche des Hohlraums 3 mit einem leitenden Überzug 6 versehen.

Die drei zueinander parallelen Schirmflächen sind leitend verbunden und stehen ebenfalls in leitenden Kontakt mit einem Schirmkontaktelement (hier nicht gezeigt). Auch bei dieser Ausführungsform können Federelemente (hier nicht gezeigt) vorgesehen sein, die in leitenden Kontakt mit dem Steckverbindergehäuse stehen.

Alle Merkmale der in dieser Schrift offenbarten, verschiedenen Ausführungsformen können beliebig miteinander kombiniert werden, ohne den zu Grunde liegenden Erfindungsgedanken zu verlassen.

### Bezugszeichenliste

### Isolierkörper mit Schirmkreuz

- 1: **Isolierkörper**

- **2**: **Erste Komponente**
- 3: Hohlraum
- 4: Flügel

- 6: leitender Überzug
- 7: Schirmkontaktelement

- **10**: **Zweite Komponente**

- 12: Zweierpaar

- 14: Federarm

- 20: Schirmelement

## Patentansprüche

1. Isolierkörper (1), der zur elektrischen Kontaktierung zumindest zweier Leiter eines anzuschließenden Kabels oder zum Aufbringen auf eine Leiterplatte vorgesehen ist, wobei der Isolierkörper (1) in eine dafür vorgesehene Kammer eines Steckverbindergehäuses einführbar ist, und
zumindest zwei.Ausnehmungen (11) für jeweils zumindest ein Kontaktelement umfasst, wobei die Kontaktelemente jeweils mit einem Leiter des anzuschließenden Kabels oder jeweils mit einer Leiterbahn der Leiterplatte verbindbar sind, und aus Kunststoff gebildet ist und als einstückiges Bauteil ausgeführt ist, **dadurch gekennzeichnet, dass** der Isolierkörper ein Schirmelement (20) aufweist, wodurch die Kontaktelemente voneinander elektromagnetisch abgeschirmt sind, dass der Isolierkörper aus zumindest einer ersten Komponente (2) und einer zweiten Komponente (10) gebildet ist,
dass die erste Komponente (2) eine Dotierung enthält, wobei an der Dotierung ein metallischer Stoff haftet und einen leitenden Überzug bildet, und dass das Schirmelement (20) aus dem leitenden Überzug der ersten Komponente (2) gebildet ist.

2. Isolierkörper nach Anspruch 1,
**dadurch gekennzeichnet, dass**
der aus einer ersten und einer zweiten Komponente (2, 10) gebildete Isolierkörper (1) inklusive des leitenden Überzugs (6) als einstückiges Bauteil ausgeführt ist.

3. Isolierkörper nach einem der vorstehenden Ansprüche,
**dadurch gekennzeichnet, dass**
das Schirmelement den Isolierkörper (1) in axialer Richtung kreuzförmig durchsetzt.

4. Isolierkörper nach einem der vorstehenden Ansprüche,
**dadurch gekennzeichnet, dass**
das Schirmelement den Isolierkörper (1) in axialer Richtung sternenförmig durchsetzt.

5. Isolierkörper nach Anspruch 1,
**dadurch gekennzeichnet; dass**
die mit einem Füllstoff dotierte erste Komponente (2) Palladiumkeime umfasst.

6. Isolierkörper nach Anspruch 1
**dadurch gekennzeichnet, dass**
der leitende Überzug (6) aus Kupfer oder einer Kupferlegierung besteht.

7. Isolierkörper nach einem der vorstehenden Ansprüche
**dadurch gekennzeichnet, dass**
ein Schirmkontaktelement (7) am Schirmelement (20) angeformt ist.

## Claims

1. Insulating body (1) which is provided for making electrical contact with at least two conductors of a cable which is to be connected or for mounting on a printed circuit board, wherein the insulating body (1) can be inserted into a chamber of a plug connector housing, which chamber is provided for the said insulating body, and comprises at least two recesses (11) for at least one contact element in each case, wherein the contact elements can each be connected to a conductor of the cable which is to be connected or can in each case be connected to a conductor track of the printed circuit board, and is formed from plastic and is designed as an integral component, **characterized in that** the insulating body has a shielding element (20), as a result of which the contact elements are electromagnetically shielded from one another, **in that** the insulating body is formed from at least one first component (2) and one second component (10), **in that** the first component (2) contains a doping, wherein a metallic substance adheres to the doping and forms a conductive coating, and **in that** the shielding element (20) is formed from the conductive coating of the first component (2).

2. Insulating body according to Claim 1, **characterized in that** the insulating body (1) which is formed from a first and a second component (2, 10), including the conductive coating (6), is designed as an integral component.

3. Insulating body according to either of the preceding claims, **characterized in that** the shielding element passes through the insulating body (1) in the axial direction in the form of a cross.

4. Insulating body according to one of the preceding claims, **characterized in that** the shielding element passes through the insulating body (1) in the axial direction in the form of a star.

5. Insulating body according to Claim 1, **characterized in that** the first component (2), which is doped with a filler, comprises palladium nuclei.

6. Insulating body according to Claim 1, **characterized in that** the conductive coating (6) is composed of copper or a copper alloy.

7. Insulating body according to one of the preceding claims, **characterized in that** a shielding contact element (7) is integrally formed on the shielding element (20).

## Revendications

1. Corps isolant (1), lequel est prévu en vue de la mise en contact électrique de tout au moins deux conducteurs d'un câble à connecter ou en vue de l'application sur un circuit imprimé, où le corps isolant (1) peut être introduit dans une chambre d'un boîtier de connecteur prévue à cet effet, et comprenant tout au moins deux évidements (11) pour respectivement tout au moins un élément de contact, où les éléments de contact peuvent respectivement être raccordés à un conducteur du câble à connecter ou peuvent respectivement être raccordés à une piste conductrice du circuit imprimé et est constitué de matière plastique et est conçu comme un élément formé d'une seule pièce,
**caractérisé en ce que**
le corps isolant présente un élément de blindage (20) permettant de réaliser le blindage électromagnétique des éléments de contact les uns par rapport aux autres ;
**en ce que** le corps isolant est formé de tout au moins un premier composant (2) et d'un deuxième composant (10) ;
**en ce que** le premier composant (2) contient un élément de dopage, où une matière métallique adhère à l'élément de dopage et forme un revêtement conducteur ; et
**en ce que** l'élément de blindage (20) est formé à partir du revêtement conducteur du premier composant (2).

2. Corps isolant selon la revendication 1,
**caractérisé en ce que**
le corps isolant (1) formé à partir d'un premier et d'un deuxième composant (2, 10) est conçu sous la forme d'un élément moulé d'une seule pièce, incluant également le revêtement conducteur (6).

3. Corps isolant selon l'une des revendications ci-dessus,
**caractérisé en ce que**
l'élément de blindage traverse le corps isolant (1) dans une direction axiale, en forme de croix.

4. Corps isolant selon l'une des revendications ci-dessus,
**caractérisé en ce que**
l'élément de blindage traverse le corps isolant (1) dans une direction axiale, en forme d'étoile.

5. Corps isolant selon la revendication 1,
**caractérisé en ce que**
le premier composant (2) doté d'une matière de remplissage comprend des germes de palladium.

6. Corps isolant selon la revendication 1,
**caractérisé en ce que**
le revêtement conducteur (6) est constitué de cuivre ou d'un alliage de cuivre.

7. Corps isolant selon l'une des revendications ci-dessus
**caractérisé en ce que**
un élément de contact de blindage (7) est moulé sur l'élément de blindage (20).
